# EUROPEAN PATENT SPECIFICATION

(11) **EP 1 587 604 B1**
(45) Date of publication and mention of the grant of the patent: **29.11.2006**
(21) Application number: 04703489.7
(22) Date of filing: 20.01.2004
(51) Int. Cl.: B01D 53/68, B01D 53/70, A62D 3/00

(54) **PROCESS FOR DECOMPOSING FLUORINE COMPOUNDS**
VERFAHREN ZUM ZERSETZEN VON FLUORVERBINDUNGEN
PROC D DE D COMPOSITION DE COMPOS S DE FLUOR

(30) Priority: 29.01.2003 JP 2003020885
(43) Date of publication of application: 26.10.2005
(73) Proprietor: Showa Denko K.K., Tokyo 105-8518 (JP)
(72) Inventor: OKA, Masakazu, c/o Showa Denko K.K., Kawasaki-shi, Kanagawa 2100867 (JP)
(74) Representative: Strehl Schübel-Hopf & Partner
(86) International application number: PCT/JP2004/000432
(87) International publication number: WO 2004/067152

(56) References cited:
- EP-A- 1 101 524
- EP-A- 1 123 727
- EP-A- 1 129 775
- US-A1- 2002 032 358
- YAMAMOTO T; YASUHARA A; SHIRAISHI F; KAYA K; ABE T: "THERMAL DECOMPOSITION OF HALON ALTERNATIVES" CHEMOSPHERE, vol. 35, no. 3, 1997, pages 643-654, XP002285450
- DATABASE INSPEC [Online] THE INSTITUTION OF ELECTRICAL ENGINEERS, STEVENAGE, GB; 2002, WATANABE T: "Thermal decomposition treatment of halon with solid alkali" XP002285451 Database accession no. 7583346 & BULL. RES. LAB. NUCL. REACT., vol. 26, 2002, page 54, Bull. Res. Lab. Nucl. React. (Japan), Bulletin of the Research Laboratory for Nuclear Reactors, 2002, Tokyo Inst. Technol, Japan ISSN: 0387-6144

## Description

### Technical Field

The present invention relates to a process for decomposing fluorine compounds. More specifically, the present invention relates to a process for decomposing fluorine compounds, having iodine within the molecule, to render them harmless.

### Background Art

Heretofore, so-called PFC (perfluorocarbon) gases such as CF₄, C₂F₆ and C₄F₈ have been mainly used in the etching or cleaning performed by using a silicon-based compound. However, these gases have a problem in that their lifetime in air is long and their global warming coefficient is high. From the standpoint of preventing global warming, a great reduction in their use has been mandated by the Kyoto Protocol (COP3). To satisfy this requirement, the development of etching or cleaning materials having a short lifetime in air and a low global warming coefficient is proceeding.

On the other hand, the integration degree of semiconductors is increasing at a rate of nearly 1.5 times per year and the precision in the processing technique therefor is also becoming higher. Recently, the development of etching materials or semiconductor production devices capable of nano-order fine processing has also proceeded.

In recent years, fluorine compounds having iodine within the molecule, such as CF₃I, are attracting attention because the iodine-containing fluorine compounds are expected to enable fine processing and are low in the global warming effect.

Furthermore, in order to reduce emission of fluorine compound gases having a high global warming coefficient (for example, CF₄ and C₂F₆), many devices for decomposing a fluorine compound gas after use and rendering it harmless are being studied. For example, (1) a burning and decomposition method of treating the gas together with fuel (see, WO94/05399), (2) a thermal decomposition method of using a reactive agent such as silica and zeolite (see, Japanese Unexamined Patent Publication No. 7-116466 (JP-A-7-116466)) and (3) a catalytic decomposition method of using alumina or the like (see US 2002/032358 and Japanese Unexamined Patent Publication No. 10-286434 (JP-A-10-286434)) are known.

However, the gas to be treated by these decomposition devices is a fluorine compound containing carbon, fluorine, chlorine or hydrogen, and the devices are not considered suitable to decompose a fluorine compound having iodine within the molecule and render it harmless. This is because the iodine-containing fluorine compound may be decomposed by any method but iodine is contained in the gas after decomposition and must be separately removed.

In the case where a fluorine compound having iodine within the molecule is used for etching, a difficult-to-decompose fluorine compound having a high global warming coefficient is also produced as a by-product in the form of a perfluorocarbon such as CF₄ or the decomposed iodine is also contained in the gas and therefore, these compounds must be also decomposed and/or rendered harmless at the same time.

Iodine is contained in gargles or the like and is known to have an antiseptic effect. However, it is also known that an excess ingestion of iodine causes thyropathy. Therefore, emission of untreated iodine, as it is, into the environment is not preferred.

Furthermore, iodine as a by-product produced by the use of a fluorine compound having iodine within the molecule in an etching device or iodine as a by-product resulting from decomposition of the fluorine compound by a decomposing device is in a gaseous state. The acceptable concentration of gaseous iodine is as low as 0.1 ppm and the contact of this gas with a human body is dangerous. Therefore, the amount of gaseous iodine must be reduced to a harmless level.

### Disclosure of Invention

Under these circumstances, an object of the present invention is to provide a process capable of decomposing a fluorine compound having iodine within the molecule or a compound contained in an exhaust gas generated on use of this fluorine compound in etching, rendering the compound harmless by removing decomposed products, and realizing safe discharge into the environment.

As a result of extensive investigations to attain the above-described object, the present inventors have found that a fluorine compound having iodine within the molecule can be rendered harmless by decomposing it using a decomposition reactive agent containing alumina and an alkaline earth metal compound preferably at a temperature of 200°C or more, fixing the produced chlorine, fluorine and/or sulfur as a chloride, a fluoride and/or a sulfate of an alkaline earth metal in the reactive agent, and adsorbing iodine which cannot be fixed as a salt of an alkaline earth metal, to an adsorbent and, if desired, when a net-like substance for fixing iodine of vapor pressure or more is provided at the inlet portion of adsorbent layer, the pathway can be prevented from clogging due to solidification of iodine of vapor pressure or more at the adsorbent layer inlet. The present invention has been accomplished based on this finding.

Accordingly, the present invention relates to processes for decomposing fluorine compounds described in [1] to [15] below.
[1] A process for decomposing a fluorine compound, comprising bringing a gas containing a fluorine compound having iodine within the molecule into contact with a reactive agent containing alumina and an alkaline earth metal compound, and then bringing the gas, obtained after the contact, into contact with an adsorbent.
[2] The process as described in [1] above, wherein the alumina is pseudo-boehmite alumina.
[3] The process as described in [1] or [2] above, wherein the alkaline earth metal compound is a carbonate of magnesium, calcium, strontium and/or barium.
[4] The process as described in any one of [1] to [3] above, wherein the reactive agent contains an oxide of at least one metal selected from the group consisting of copper, tin, nickel, cobalt, chromium, molybdenum, tungsten and vanadium.
[5] The process as described in any one of [1] to [4] above, wherein the alkali metal content of the reactive agent is 0.1 mass% or less.
[6] The process as described in any one of [1] to [5] above, wherein the reactive agent is a granule having a particle size of 0.5 to 10 mm.
[7] The process as described in [6] above, wherein the water content of the reactive agent is 1 mass% or less.
[8] The process as described in any one of [1] to [7] above, wherein the fluorine compound having iodine within the molecule is contacted with the reactive agent at a temperature of 200°C or more.
[9] The process as described in any one of [1] to [8] above, wherein the gas containing a fluorine compound having iodine within the molecule is an exhaust gas generated during use of the fluorine compound for etching or cleaning.
[10] The process as described in any one of [1] to [9] above, wherein the gas containing a fluorine compound having iodine within the molecule is contacted with the reactive agent at a temperature of 500°C or more in the presence of oxygen to thereby restrain the production of carbon monoxide.
[11] The process as described in any one of [1] to [10] above, wherein the adsorbent is at least one adsorbent selected from the group consisting of activated carbon, alumina, silica gel and zeolite.
[12] The process as described in any one of [1] to [11] above, wherein the gas is contacted with the adsorbent at a linear velocity of 20 Nm/min or less.
[13] The process as described in any one of [1] to [12] above, wherein a layer for fixing iodine is provided in front of the layer packed with the adsorbent.
[14] The process as described in [13] above, wherein the layer for fixing iodine has a porosity of 80% or more.
[15] The process as described in any one of [1] to [14] above, wherein the fluorine compound having iodine within the molecule is at least one compound selected from the group consisting of fluoroiodocarbon, hydrofluoroiodocarbon, chlorofluoroiodocarbon and hydrochlorofluoroiodocarbon.

### Brief Description of the Drawings

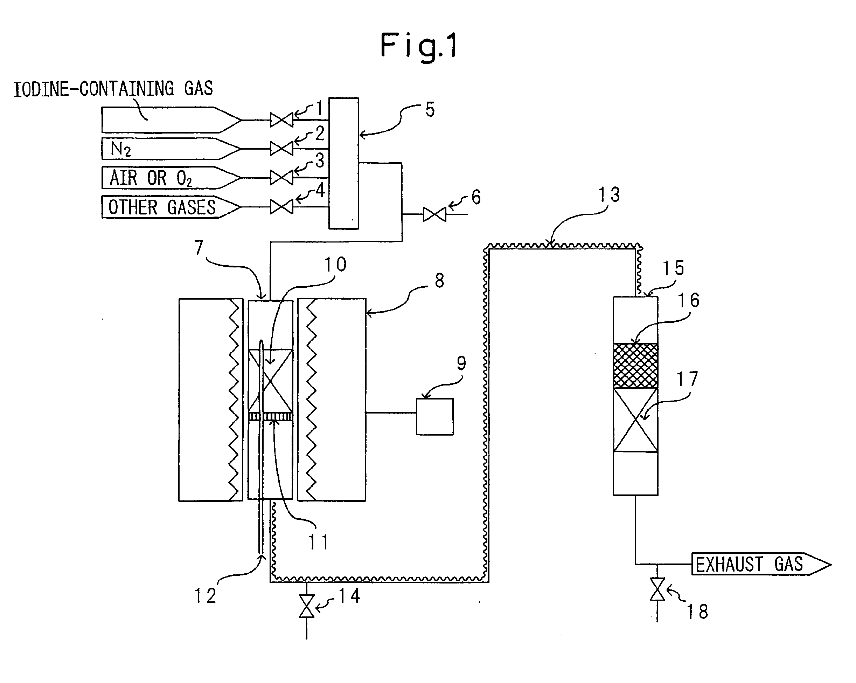

Fig. 1 is an equipment arrangement diagram showing one example of the apparatus for practicing the process of the present invention.

### Best Mode for Carrying Out the Invention

The preferred embodiment of the present invention is described in detail below.

Examples of the fluorine compound having iodine within the molecule, which can be decomposed and rendered harmless by the process of the present invention, include compounds such as CF₃I, CF₂I₂, CFI₃, CHF₂I, CH₂FI, CClF₂I, CClFI₂, CHFI₂, C₂F₅I, C₂F₄I₂, C₂ClF₄I, C₂ClF₃I₂, C₂Cl₂F₂I₂, C₂HF₄I, C₂HF₃I₂, C₂H₂F₃I, C₂HClF₃I, C₂F₃I, C₂F₂I₂, C₂HF₂I, C₂F₅IO and C₂F₄I₂O.

In decomposing such a fluorine compound having iodine within the molecule according to the process of the present invention, the gas of this compound may be diluted with an inert gas such as helium, argon and nitrogen or with air, or the gas may be a mixed gas which is liquid at ordinary temperature but, when accompanied with other inert gas or air, comes to contain the vapor thereof in an amount of 0.01 vol% or more. The gas may be a single gas or may be a mixture of two or more gases.

According to the present invention, for example, a hard-to-decompose compound having a high global warming coefficient, such as perfluorocarbon (e.g., CF₄, C₂F₆) produced as a by-product during use in etching or the like, and a compound such as HF, SiF₄ and COF₂, can be also rendered harmless by decomposing such a compound in the same manner and fixing it as an alkaline earth metal fluoride (for example, CaF₂). Furthermore, iodine which is difficult to fix as an alkaline earth metal salt can be rendered harmless by removing it using an adsorbent.

Here, the reason why the iodine component after decomposition cannot be fixed as an alkaline earth metal salt unlike the fluorine component is because the alkaline earth metal iodide is unstable as compared with alkaline earth metal fluoride and cannot be stably present under the temperature condition of the thermal decomposition.

Therefore, iodine incapable of being fixed as alkaline earth metal iodide comes out from the outlet of a decomposition reactor where the iodine-containing fluorine compound is decomposed by a decomposition reactive agent, and this iodine must be removed from the standpoint of ensuring safety of the environment and of living things.

To cope with this, in the present invention, an adsorbent for removing iodine is provided in the post-stage of decomposition reactor, whereby iodine, which is to fix on a reactive agent, is removed and rendered harmless.

The adsorbent for removing iodine may be a generally available commercial product such as active carbon, alumina, silica gel and zeolite, or a product enhanced in the adsorbing ability by performing a special treatment such as attachment of a metal or the like on the commercially available product. In particular, active carbon is preferred because it exhibits a high adsorbing ability in the removal of iodine and is inexpensive. However, activated carbon may burn under the condition of, for example, high oxygen concentration by the effect of heat generation due to heat of adsorption and therefore, a noncombustible adsorbent such as a molecular sieve is more preferably used.

The temperature at the adsorption and removal of iodine is preferably as low as possible because the adsorbed amount increases, however, a cooling device or the like need not be installed so as to avoid a complicated constitution of the removing device. The adsorption temperature is preferably 100°C or less, more preferably 50°C or less.

Iodine is a sublimable substance and, therefore, the iodine is partially solidified at a temperature of sublimation pressure or less. If the passing of gas is continued in such a state, this may cause clogging of the pipeline. In this case, the clogging can be prevented by heating the pipeline connecting the decomposition reactor and the adsorption column to a temperature of vapor pressure or more and thereby inhibiting the iodine-containing gas from dropping to a temperature of sublimation pressure or less.

Furthermore, iodine which is gasified in the high-temperature area may be cooled and solidified at the adsorbent inlet to cause clogging and stop the passing of gas. This clogging by iodine can be prevented by heating the container packed with the adsorbent to a temperature of not causing solidification of iodine. Also, in the case of dropping the temperature to the vapor pressure or less of iodine because a lower temperature is advantageous for the adsorption as described above, a coarse-meshed wire gauze or the like is deposited on the inlet portion having a decreased temperature so as to prevent the solidification at the adsorbent inlet. By this treatment, iodine at higher than the sublimation pressure can be fixed at that portion and iodine of only sublimation pressure can be passed to the adsorbent, as a result, iodine more than the saturated vapor pressure cannot be passed to the adsorbent and therefore, the solidification at the adsorbent inlet can be prevented. The volume of the wire gauze may be appropriately determined according to the amount of iodine produced by decomposition or the adsorption temperature. However, if the volume of wire gauze is too large, the amount of adsorbent decreases to cause an early break-through, whereas if it is too small, clogging due to iodine occurs. Therefore, the volume of wire gauze is preferably from 1/100 to 1/2, more preferably from 1/10 to 1/4, of the adsorbent volume. In addition, if the wire gauze packed is too fine, clogging disadvantageously occurs due to the iodine being fixed. Therefore, the roughness of wire gauze used is, in terms of porosity, preferably 80% or more, more preferably 90% or more. This porosity shows the percentage of portion except for those used for fixing, such as wire gauze, occupying in a certain volume. That is, the porosity is 100% when a gauze or the like is not present, whereas the porosity is 0% when all portions are filled with the gauze.

When clogging occurs due to iodine, gas cannot pass through. Therefore, whether clogging is brought about by iodine must be monitored. This may be monitored by a method of providing a manometer before the portion considered to clog and confirming whether the pressure is raised by clogging, or a method of providing a flow meter at the inlet and the outlet and confirming whether the same linear velocity is maintained.

If the linear velocity into the adsorbent is too large, this disadvantageously incurs a problem that break-through is readily caused or pressure drop increases, whereas if it is too small, a large-size adsorption column is necessary and this is not preferred in view of installation space or handling. Accordingly, the linear velocity is preferably from 0.1 to 20 Nm/min, more preferably from 1 to 10 Nm/min.

As the adsorbent for removing iodine used in the present invention, a commercially available adsorbent can be used as described above. For example, Coconut Shell Activated Carbon (produced by Ajinomono-Fine-Techno Co., Inc.) and Molecular Sieve 13X (produced by Union Showa) can be preferably used. An adsorbent supplied from a manufacturer can be packed as it is into the adsorption column and used. In the case of using an adsorbent stored for a long period of time, this can be used as if it was brand-new by, for example, drying it at 150 to 300°C in an inert gas flow.

The shape of the adsorbent is not particularly limited and the removal by adsorption can be performed with any shape such as columnar form or spherical form. As for the size of adsorbent, if the particle size is too large, the surface area participating in the adsorption and diffusion of iodine becomes relatively small and the diffusion proceeds at a low rate. On the other hand, if the particle size is too small, the surface area participating in the adsorption and diffusion of iodine becomes relatively large and the diffusion proceeds at a high rate, however, as the amount of gas to be treated becomes large, the differential pressure also becomes large and this hinders the miniaturization or the like of the adsorption container. Accordingly, the particle size of adsorbent is preferably from 0.5 to 10 mm, more preferably from 1 to 5 mm.

The reactive agent for decomposition used in the present invention comprises alumina and an alkaline earth metal compound and has a function of decomposing a fluorine compound having iodine within the molecule and fixing the produced chlorine, fluorine and/or sulfur as an alkaline earth metal salt.

The alumina used is not particularly limited but it is important to select an appropriate starting material having few impurities. In the present invention, for example, an activated alumina or a pseudo-boehmite alumina can be used as the alumina raw material. A pseudo-boehmite alumina is particularly preferred.

The content of alkali metals contained as impurities in the alumina is preferably 0.1 mass% or less, more preferably 0.01 mass% or less, still more preferably 0.001 mass% or less.

Examples of the alkaline earth metal compound which can be used include a carbonate, a hydroxide and an oxide of alkaline earth metal. Among these, carbonates of magnesium, calcium, strontium and barium are preferred, and a carbonate of calcium is more preferred. Similarly to alumina, the total content of alkali metals contained as impurities in the alkaline earth metal compound is preferably 0.1 mass% or less, more preferably 0.01 mass% or less, still more preferably 0.001 mass% or less.

The reactive agent for use in the present invention may further contain at least one oxide of copper, tin, nickel, cobalt, chromium, molybdenum, tungsten and vanadium. Examples of the metal oxide include copper oxide (CuO), tin oxide (SnO₂), nickel oxide (NiO), cobalt oxide (CoO), chromium oxide (Cr₂O₃), molybdenum oxide (MoO₃), tungsten oxide (WO₂) and vanadium oxide (V₂O₅). Among these, copper oxide and tin oxide are preferred. For example, in the case where copper oxide or tin oxide is used in the reactive agent and present together with alumina and an alkaline earth metal compound, carbon monoxide produced by the decomposition depending on the kind of fluorine compound can be oxidized even to carbon dioxide in a low oxygen partial pressure. Similarly to the above-described raw materials, the total content of alkali metals contained as impurities in this metal oxide is preferably 0.1 mass% or less, more preferably 0.01 mass% or less, still more preferably 0.001 mass% or less.

In the reactive agent for use in the present invention, the content ratio of alumina and an alkaline earth metal compound added to the reactive agent is, in terms of mass ratio, preferably from 1:9 to 1:1, more preferably from 1:4 to 2:3. The alumina in the reactive agent efficiently decomposes a fluorine compound by coexisting with an alkaline earth metal compound and assuming that the mass of the entire reactive agent is 1, the alumina content is preferably 0.1 or more by mass at least at the initial time of decomposition reaction, though the content may fluctuate as the decomposition reaction proceeds. If this ratio is less than 0.1, the fluorine compound may not be sufficiently decomposed. However, if alumina is contained in an amount exceeding the mass ratio of 0.5, this is accompanied with reduction in the amount of alkaline earth metal compound and the effective utilization factor of reactive agent decreases.

The content ratio of metal oxide is preferably, in terms of the mass ratio to the total amount of alumina and alkaline earth metal compound, from 1:99 to 5:95. If this ratio is too small, a sufficiently high effect may not be obtained, whereas if it is excessively large, the effect may be saturated, the total amount of alumina and alkaline earth metal compound relatively decreases and the fluorine compound may not be decomposed with good efficiency.

In granulating the reactive agent by blending alumina and an alkaline earth metal compound and further blending one or more oxide of copper, tin, nickel, cobalt, chromium, molybdenum, tungsten and vanadium, water or, depending on the particle size of raw material, water and a binder, can be added. The binder is not particularly limited as long as it does not affect the blended raw materials. Assuming that the total mass of raw materials blended is 1, the binder can be added in an amount of 0.03 to 0.05 in terms of the mass ratio to the total mass. The binder is preferably fine powder alumina. By adding fine powder alumina, respective raw materials are more improved in the dispersibility, and a difficulty in the granulation of an alkaline earth metal compound can be overcome. The particle size of alumina added as the binder is suitably 0.1 µm or less and the total content of alkali metals contained as impurities is preferably 0.1 mass% or less, more preferably 0.01 wt% or less. However, as long as the binder does not affect the capability of the obtained reactive agent for decomposition, the kind and the amount of binder are not limited.

As described above, each of the raw materials blended in the reactive agent, including the fine powder alumina added as the binder, preferably has a total alkali metal content of 0.1 mass% or less. Also, the total alkali metal content in the reactive agent is preferably 0.1 mass% or less. If the total alkali metal content in the reactive agent exceeds 0.1 mass%, the active sites on the alumina surface decrease and this is considered to sometimes cause reduction in the decomposition ratio particularly of PFC gases such as CF₄ and C₂F₆.

In producing the granular reactive agent for use in the present invention, respective raw materials are blended and then kneaded while adding an appropriate amount of water, and the kneaded product is granulated to provide a granular article. The granular article is then dried at from 100 to 200°C in an inert gas such as nitrogen or in air so as to evaporate water. The reasons why the reactive agent is used as a granular article are to enhance the decomposing activity of reactive agent and to increase the hardness so as to prevent crushing or flouring during filling into a reactor or handling. For this purpose, the granular article is preferably further calcined. More specifically, the granulated and dried article is calcined at from 400 to 700°C, preferably from 500 to 700°C in an inert gas such as nitrogen or in air. The reasons why the granular article is calcined at 400°C or more are to further evaporate water added during the granulation and thereby enhance the decomposing activity and to increase the hardness. If the calcining temperature exceeds 700°C, the decomposing ratio (activity) of reactive agent sometimes decreases though it is not clearly known whether this is ascribable to the decomposition of alkaline earth metal compound (for example, CaCO₃→CaO+CO₂). In other words, it is important to almost completely remove the bound water of alumina (pseudo-boehmite) at 700°C or less where the activity of reactive agent does not decrease. The water content in the calcined reactive agent is preferably such that the amount of water content released on heating at 550°C in an inert gas or air atmosphere is 1 mass% or less. As for the equipment used for calcining, the calcining may be performed in a continuous system such as rotary kiln or in a stationary furnace.

As described above, the reactive agent for decomposing a fluorine compound, which is used in the present invention, comprises alumina and an alkaline earth metal compound as essential components. Furthermore, a metal oxide such as CuO, SnO₂, NiO, CoO, Cr₂O₃, MoO₃, WO₂, and V₂O₅, may also be added to the reactive agent so that carbon monoxide produced by the fluorine compound can be oxidized at a low oxygen partial pressure. The reactive agent is preferably in a granular form for increasing opportunities of contact with a fluorine compound to be decomposed. If the particle size of reactive agent is too large, the surface area participating in the adsorption and diffusion of fluorine compound gas becomes relatively small and the diffusion proceeds at a low rate. On the other hand, if the particle size is too small, the surface area participating in the adsorption and diffusion becomes relatively large and the diffusion proceeds at a high rate, however, as the amount of gas to be treated increases, the differential pressure also becomes large and this hinders the miniaturization or the like of reactor. Accordingly, the particle size of reactive agent is suitably from 0.5 to 10 mm, preferably from 1 to 5 mm.

The process for decomposing a fluorine compound and rendering it harmless of the present invention is described below. An iodine-containing fluorine compound having is contacted with a reactive agent, produced by the above-described method, at an appropriate temperature and, as a result, the fluorine compound is decomposed and chlorine, fluorine and/or sulfur produced by the decomposition are fixed on the reactive agent as a chloride, a fluoride or the like of alkaline earth metal. Furthermore, when, for example, a carbonate is used as the alkaline earth metal compound, carbon derived from the fluorine compound is oxidized by oxygen released upon decomposition of the carbonate and is mostly released as CO₂ or CO. Here, iodine which is generated by the decomposition and cannot be fixed can be removed by contacting it with an adsorbent. In this case, the reaction temperature varies depending on the kind of compound contained in the untreated gas.

CF₃I, which is a fluorine compound having iodine within the molecule, thermally decomposes at 500 to 600°C but when the above-described decomposition reactive agent is used, this compound decomposes at 200 to 300°C. In the case where many kinds of PFC or HFC (hydrofluorocarbon) are used or contained as in the exhaust gas after etching or cleaning in the production process of a semiconductor, the gases produced as byproducts all must be also rendered harmless. For example, PFC which is a by-product gas is classified as a difficult-to-decompose compound of the fluorine compounds. Particularly, CF₄, C₂F₆ and the like are most difficult to decompose and for decomposing these gases only by thermal decomposition, a high temperature of 1,200 to 1,400°C is necessary. However, when the above-described reactive agent is used, these gases can be decomposed at 500°C or more. In this way, the decomposition temperature varies over a fairly large range depending on the kind of compound. Therefore, it is important to set the reactor at an optimal temperature according to the kind of compound.

As the reaction temperature varies depending on the kind or structure of compound, the reaction temperature is suitably set to 500°C or more. Depending on the kind of compound, the treated gas (exhaust gas) sometimes contains CO. However, by allowing oxygen to coexist in the gas to be treated, CO can be easily oxidized into CO₂ and the gas can be rendered completely harmless.

The fluorine compound concentration in the gas to be treated is not particularly limited, however, an excessively low concentration is disadvantageous in view of profitability. On the other hand, if the concentration is too high, the reaction temperature elevates due to the heat generated by the decomposition, though this may vary depending on the kind of compound. Therefore, in order to avoid occurrence of the case where the temperature within the reactor can hardly be controlled or to prevent iodine from clogging the pipeline, the fluorine compound concentration is preferably from 0.01 to 10 vol%. The gas to be treated is more preferably diluted with an inert gas or an oxygen-containing gas (including air) to have a fluorine compound concentration of 0.1 to 5 vol%, still more preferably from 0.1 to 3 vol%. However, when the reaction temperature can be controlled by enforcedly removing the heat generated upon decomposition, the fluorine compound concentration is not limited to the above-described range.

In this way, suitable reaction conditions are preferably established according to respective cases by taking account of the kind and concentration of the fluorine compound in the gas subjected to the decomposition treatment, the oxygen gas concentration in the gas to be treated, SV (space velocity), LV (linear velocity) and the mixed state with other gases.

The decomposition treatment may be performed using a decomposition apparatus comprising a reactor filled with the above-described reactive agent, an inlet for the gas to be treated, which is provided to communicate with the inside of the reactor, a gas outlet provided for discharging the gas out of the reactor after the reaction, a furnace for housing the reactor, and a heat source for elevating the furnace atmosphere to a predetermined temperature, where the inlet for gas to be treated is connected with a fluorine compound gas source through a pipeline.

Fig. 1 is a view showing one example of the apparatus for practicing the process of the present invention. While previously passing a constant amount of carrier gas from a nitrogen gas supply line 2 or from an air or oxygen gas supply line 3, a reactive agent 10 filled in a reactor 7 is heated to a predetermined temperature by an electric heater 8 and controlled to a constant temperature by using a temperature sensor 12 provided in the reactor 7 and a temperature controlling unit 9.

At the predetermined temperature, gases to be treated are introduced into a mixing chamber 5 through respective valves from a supply line 1 for the gas of a fluorine compound having an iodine atom within the molecule and from the nitrogen gas supply line 2 or air or oxygen supply line 3. If desired, other gases are introduced into the mixing chamber 5 from a supply line 4. Then, the mixed gas to be treated is introduced into the reactor 7 through a gas inlet tube. The gas to be treated, which is introduced into the reactor 7, is contacted with the reactive agent heated to a predetermined temperature and thereby decomposed. The treated gas (exhaust gas) after decomposition is introduced into an adsorption column 15 through a pipeline kept warm by a pipeline heating heater 13. In the adsorption column 15, an iodine fixing layer 16 is provided in the upper part and an adsorbent 17 is filled in the downstream part thereof. Incidentally, for sampling a gas, sampling ports 6 for analysis of reactor inlet gas, 14 for analysis of reactor outlet gas and adsorption column inlet gas, and 18 for analysis of adsorption column outlet gas may be provided, whereby the components of each gas can be analyzed.

In this way, the fluorine compound in the gas to be treated is almost completely decomposed and the iodine discharged from the reactor is also removed by adsorption. The halogens such as fluorine and the carbon component in the decomposed fluorine compound react with the alkaline earth metal compound in the reactive agent, whereby, for example, the fluorine component is fixed on the reactive agent as a stable alkaline earth metal fluoride such as CaF₂, the carbon component is mostly discharged as CO₂ together with the diluting gas such as nitrogen gas, and the iodine is fixed on the adsorbent. Accordingly, the treated gas becomes a harmless gas substantially free of harmful materials such as fluorine component, iodine or carbon monoxide.

The decomposition reaction terminates when the decomposing ability of reactive agent filled is exhausted. This end point of decomposition reaction is known by the time when the fluorine compound is first detected. The fluorine compound may be decomposed in a batch system where, when the fluorine compound is detected and the reactive agent loses the decomposing ability, the operation of apparatus is stopped and after newly filling the reactive agent, the decomposition reaction is re-started, or by a system where, in the same apparatus, the reactor is sequentially exchanged with a spare reactor previously filled with the reactive agent.

The break-through of adsorbent can be known by monitoring the iodine concentration at the adsorbent outlet. When break-through is reached, the adsorption column is exchanged with a spare iodine adsorption column previously filled with the adsorbent, whereby the adsorption can be again performed.

In order to continuously use the batch system, a multiple tower switch system may also be adopted, where a plurality of reactors and adsorption containers of the same type are juxtaposed, and the reactive agent of one reactor and/or the adsorbent of one adsorption container is exchanged while another reactor and another adsorption container are operating, or a reactor previously filled with the reactive agent and/or an adsorption container previously filled with the adsorbent is exchanged and when one reactor and/or one adsorption column is stopped, the gas passage is switched to another reactor or adsorption column.

The present invention is further illustrated below by referring to Examples, however, the present invention should not be construed as being limited to these

### Examples.

### Preparation of Reactive agent

The substances shown in Table 1 below were used as the raw materials of reactive agent.

**TABLE 1**

| Name of Raw Material of Reactive Agent | Particle Size [µm] | Specific Surface Area [m²/g] | Impurities [mass%] | | | |
|---|---|---|---|---|---|---|
| | | | Na | K | Fe | Si |
| CaCO₃ (high-purity calcium carbonate) | 40 | | 0.0012 | 0.0005 | <0.0001 | <0.0001 |
| Al₂O₃[AlO(OH)] | 60 | 241 | 0.0027 | <0.001 | Fe₂O₃ | SiO₂ |
| (pseudo-boehmite alumina) | | | | | 0.0034 | 0.0066 |
| CuO (Cupric oxide) | 4 to 10 | | <0.01 | <0.01 | <0.01 | <0.01 |
| SnO₂ (stannic oxide) | 4 to 10 | | <0.01 | <0.01 | <0.01 | <0.01 |
| Binder (ultrafine powder alumina) | <0.1 | | <0.001 | <0.001 | <0.001 | <0.001 |

The substances shown in Table 1 were used as raw materials and mixed in a Henschel mixer and, after adding water, the mixture was granulated and then heated at 110°C for 3 hours. The resulting granules were sieved to obtain a granular product having a particle size of 0.85 to 2.8 mm. The obtained granular product was dehydration calcined by a heat treatment at a calcining temperature of 550°C for 3 hours in an air atmosphere to prepare a reactive agent.

### Decomposition Treatment of Gas to be Treated

The process of the present invention was performed using an apparatus having the same principles as the apparatus shown in Fig. 1. Namely, along the axial center of a cyclic furnace (electric capacity: 1.5 KW) with a heating element capable of generating heat on passing of an electric current, an SUS reaction tube having an external form of 3/4 inch (thickness: 1 mm) and a length of 50 cm was inserted and 25 ml of the reactive agent for decomposition was filled in the reactor. In the region extending from the outlet of reaction tube to the inlet of adsorption column, a ribbon heater was wound and heated to 60°C so as to prevent fixing of iodine. As the adsorption column, an SUS adsorption column having an exterior form of 1/2 inch (thickness: 1 mm) and a length of 50 cm was used and at the inlet of adsorption column, 2 ml of an SUS packing material (porosity: 95%) was packed and 10 ml of an adsorbent was filled.

A fluorine compound gas having iodine within the molecule was used as a gas to be decomposed and a test where a PFC gas was allowed to coexist with the fluorine compound gas was also performed.

In either test, the gas to be treated was introduced after charging of the heating element was started, while controlling the quantity of electricity in the cyclic furnace so that the temperature measured by a thermocouple inserted into the center part of the reactive agent (the site reaching a highest temperature in the bulk of the reactive agent) could be maintained at a predetermined temperature. In Table 2 below, the decomposition reaction temperature indicates this temperature maintained during the reaction.

The gas to be treated and the treated gas were sampled from respective sampling ports and the analysis results of each composition are shown in Table 2. In the analysis, O₂, N₂ and fluorine compound were analyzed using a gas analyzer, and iodine was sampled into a detector tube and/or an absorption bottle containing potassium iodide and analyzed by titration.

### Example 1

The decomposition reaction and removal by adsorption were performed under the conditions shown in Table 2.

In the reactor outlet gas, the concentration of the objective gas of treatment was less than the detection limit. Also, in the adsorption column outlet gas, iodine could be removed to less than the allowable concentration.

### Example 2

The operation of Example 1 was repeated except for changing the decomposition reaction temperature to 300°C. In the reactor outlet gas, the concentration of the objective gas of treatment was less than the detection limit. Also, in the adsorption column outlet gas, iodine could be removed to less than the allowable concentration.

### Example 3

The operation of Example 2 was repeated except for changing the concentration of the objective gas of treatment to 0.1 vol%. In the reactor outlet gas, the concentration of the objective gas of treatment was less than the detection limit. Also, in the adsorption column outlet gas, iodine could be removed to less than the allowable concentration.

### Example 4

The decomposition reaction and removal by adsorption operation were performed by adding CF₄ as the objective gas of treatment under the conditions shown in Table 2. In the reactor outlet gas, the concentration of the objective gas of treatment was less than the detection limit even in the presence of perfluorocarbon. Also, in the adsorption column outlet gas, iodine could be removed to less than the allowable concentration.

### Example 5

The operation of Example 4 was repeated except for changing the decomposition reaction temperature to 300°C. In the reactor outlet gas, CF₄ could be little decomposed. The concentration of CF₃I was less than the detection limit. In the adsorption column outlet gas, iodine could be removed to less than the allowable concentration.

### Example 6

The operation of Example 5 was repeated except for changing the adsorbent to activated carbon. In the reactor outlet gas, the concentration of the objective gas of treatment was less than the detection limit. Also, in the adsorption column outlet gas, iodine could be removed to less than the allowable concentration.

**TABLE 2**

| Example | Reactor Inlet Conditions and Treatment Conditions | | Treatment Results, Reactor Outlet and Adsorption Column Outlet | | | | | |
|---|---|---|---|---|---|---|---|---|
| | Objective Gas of Treatment | Kind of Diluting Gas | | | | | | |
| 1 | CF₃I: 1.2 vol% | O₂/N₂=3/97 | Results (reactor outlet gas) | | | | | |
| | Decomposition reaction temperature: 550°C Adsorbent: MS-13X | | | 1 hr | 2 hr | 3 hr | 5 hr | 10 hr |
| | | | CF₃I Decomposition ratio, % | >99.9 | >99.9 | >99.9 | >99.9 | >99.9 trace of CF₄ |
| | | | I₂ Concentration, vol % | 0.54 | 0.57 | 0.63 | 0.58 | 0.59 |
| | Total flow rate: 190 Nml/min | | Results (adsorption column outlet gas) | | | | | |
| | | | I₂ Concentration, vol ppm | <0.1 | <0.1 | <0.1 | <0.1 | <0.1 |
| 2 | CF₃I: 1.2 vol% | O₂/N₂=3/97 | Results (reactor outlet gas) | | | | | |
| | Decomposition reaction temperature: 300°C Adsorbent: MS-13X | | | 1 hr | 2 hr | 3 hr | 5 hr | 10 hr |
| | | | CF₃I Decomposition ratio, % | >99.9 | >99.9 | >99.9 | >99.9 | >99.9 trace of CF₄ |
| | Total flow rate: 190 Nml/min | | I₂ Concentration, vol % | 0.51 | 0.52 | 0.52 | 0.49 | 0.51 |
| | | | Results (adsorption column outlet gas) | | | | | |
| | | | I₂ Concentration, vol ppm | <0.1 | <0.1 | <0.1 | <0.1 | <0.1 |
| 3 | CF₃I: 0.1 vol% | O₂/N₂=3/97 | Results (reactor outlet gas) | | | | | |
| | Decomposition reaction temperature: 300°C Adsorbent: MS-13X | | | 1 hr | 2 hr | 3 hr | 5 hr | 10 hr |
| | | | CF₃I Decomposition ratio, % | >99.9 | >99.9 | >99.9 | >99.9 | >99.9 |
| | | | I₂ concentration, vol % | 0.052 | 0.048 | 0.049 | 0.047 | 0.051 |
| | Total flow rate: 190 Nml/min | | Results (adsorption column outlet gas) | | | | | |
| | | | I₂ Concentration, vol ppm | <0.1 | <0.1 | <0.1 | <0.1 | <0.1 |
| 4 | CF₃I: 0.5 vol% | O₂/N₂=3/97 | Results (reactor outlet gas) | | | | | |
| | CF₄: 0.5 vol% | | | 1 hr | 2 hr | 3 hr | 5 hr | 10 hr |
| | Decomposition reaction temperature: 550°C | | CF₃I Decomposition ratio, % | >99.9 | >99.9 | >99.9 | >99.9 | >99.9 |
| | Adsorbent: MS-13X | | CF₄ Decomposition ratio, % | >99.9 | >99.9 | >99.9 | >99.9 | >99.9 |
| | | | I₂ Concentration, vol % | 0.25 | 0.21 | 0.26 | 0.23 | 0.26 |
| | | | Results (adsorption column outlet gas) | | | | | |
| | | | I₂ Concentration, vol ppm | <0.1 | <0.1 | <0.1 | <0.1 | <0.1 |
| 5 | CF₃I: 0.5 vol% | O₂/N₂=3/97 | Results (reactor outlet gas) | | | | | |
| | CF₄: 0.5 vol% | | | 1 hr | 2 hr | 3 hr | 5 hr | 10 hr |
| | Decomposition reaction temperature: 300°C | | CF₃I Decomposition ratio, % | >99.9 | >99.9 | >99.9 | >99.9 | >99.9 |
| | Adsorbent: MS-13X | | CF₄ Decomposition ratio, % | 2 | 1 | 3 | 1 | 2 |
| | | | I₂ Concentration, vol % | 0.25 | 0.22 | 0.26 | 0.21 | 0.22 |
| | Total flow rate: 190 Nml/min | | Results (adsorption column outlet gas) | | | | | |
| | | | I₂ Concentration, vol ppm | <0.1 | <0.1 | <0.1 | <0.1 | <0.1 |
| 6 | CF₃I: 0.5 vol% | O₂/N₂=3/97 | Results (reactor outlet gas) | | | | | |
| | CF₄: 0.5 vol% | | | 1 hr | 2 hr | 3 hr | 5 hr | 10 hr |
| | Decomposition reaction temperature: 550°C | | CF₃I Decomposition ratio, % | >99.9 | >99.9 | >99.9 | >99.9 | >99.9 |
| | Adsorbent: Activated Carbon Y-10 | | CF₄ Decomposition ratio, % | >99.9 | >99.9 | >99.9 | >99.9 | >99.9 |
| | | | I₂ Concentration, vol % | 0.22 | 0.23 | 0.27 | 0.24 | 0.26 |
| | Total flow rate: 190 Nml/min | | Results (adsorption column outlet gas) | | | | | |
| | | | I₂ Concentration, vol ppm | <0.1 | <0.1 | <0.1 | <0.1 | <0.1 |

### Industrial Applicability

As described in the foregoing pages, according to the present invention, a fluorine compound having an iodine atom within the molecule can be decomposed, the components except for iodine can be rendered harmless, and iodine can be removed, whereby the decomposition treatment of a gas generated after a fluorine compound having an iodine atom within the molecule is used, particularly in the production of a semiconductor device, is facilitated.

## Claims

1. A process for decomposing a fluorine compound, comprising bringing a gas containing a fluorine compound having iodine within the molecule into contact with a reactive agent containing alumina and an alkaline earth metal compound, and then bringing the gas obtained after said contact, into contact with an adsorbent.

2. The process as claimed in claim 1, wherein said alumina is pseudo-boehmite alumina.

3. The process as claimed in claim 1 or 2, wherein said alkaline earth metal compound is a carbonate of magnesium, calcium, strontium and/or barium.

4. The process as claimed in any one of claims 1 to 3, wherein said reactive agent contains an oxide of at least one metal selected from the group consisting of copper, tin, nickel, cobalt, chromium, molybdenum, tungsten and vanadium.

5. The process as claimed in any one of claims 1 to 4, wherein the alkali metal content of said reactive agent is 0.1 mass% or less.

6. The process as claimed in any one of claims 1 to 5, wherein said reactive agent is a granule having a particle size of 0.5 to 10 mm.

7. The process as claimed in claim 6, wherein the water content of said reactive agent is 1 mass% or less.

8. The process as claimed in any one of claims 1 to 7, wherein the fluorine compound having iodine within the molecule is contacted with said reactive agent at a temperature of 200°C or more.

9. The process as claimed in any one of claims 1 to 8, wherein the gas containing a fluorine compound having iodine within the molecule is an exhaust gas generated during use of said fluorine compound for etching or cleaning.

10. The process as claimed in any one of claims 1 to 9, wherein the gas containing a fluorine compound having iodine within the molecule is contacted with said reactive agent at a temperature of 500°C or more in the presence of oxygen to thereby restrain the production of carbon monoxide.

11. The process as claimed in any one of claims 1 to 10, wherein said adsorbent is at least one adsorbent selected from the group consisting of activated carbon, alumina, silica gel and zeolite.

12. The process as claimed in any one of claims 1 to 11, wherein the gas is contacted with said adsorbent at a linear velocity of 20 Nm/min or less.

13. The process as claimed in any one of claims 1 to 12, wherein a layer for fixing iodine is provided in front of the layer packed with said adsorbent.

14. The process as claimed in claim 13, wherein the layer for fixing iodine has a porosity of 80% or more.

15. The process as claimed in any one of claims 1 to 14, wherein the fluorine compound having iodine within the molecule is at least one compound selected from the group consisting of fluoroiodocarbon, hydrofluoroiodocarbon, chlorofluoroiodocarbon and hydrochlorofluoroiodocarbon.

## Patentansprüche

1. Verfahren zum Zersetzen einer Fluorverbindung, welches das Kontaktieren eines Gases, das eine Fluorverbindung mit Iod im Molekül enthält, mit einem reaktiven Mittel, das Aluminiumoxid und eine Erdalkalimetallverbindung enthält, und das anschließende Kontaktieren des nach dem Kontakt erhaltenen Gases mit einem Adsorptionsmittel umfaßt.

2. Verfahren nach Anspruch 1, wobei das Aluminiumoxid Pseudo-Boehmit-Aluminiumoxid ist.

3. Verfahren nach Anspruch 1 oder 2, wobei die Erdalkalimetallverbindung ein Carbonat von Magnesium, Calcium, Strontium und/oder Barium ist.

4. Verfahren nach einem der Ansprüche 1 bis 3, wobei das reaktive Mittel ein Oxid mindestens eines Metalls enthält, das aus der Gruppe ausgewählt ist, die aus Kupfer, Zinn, Nickel, Kobalt, Chrom, Molybdän, Wolfram und Vanadium besteht.

5. Verfahren nach einem der Ansprüche 1 bis 4, wobei der Alkalimetallgehalt des reaktiven Mittels 0,1 Massen-% oder weniger ist.

6. Verfahren nach einem der Ansprüche 1 bis 5, wobei das reaktive Mittel ein Granulat mit einer Teilchengröße von 0,5 bis 10 mm ist.

7. Verfahren nach Anspruch 6, wobei der Wassergehalt des reaktiven Mittels 1 Massen-% oder weniger ist.

8. Verfahren nach einem der Ansprüche 1 bis 7, wobei die Fluorverbindung mit Iod im Molekül mit dem reaktiven Mittel bei einer Temperatur von 200°C oder höher kontaktiert wird.

9. Verfahren nach einem der Ansprüche 1 bis 8, wobei das Gas, das eine Fluorverbindung mit Iod im Molekül enthält, ein Abgas ist, das während der Verwendung der Fluorverbindung zum Ätzen oder Reinigen erzeugt wird.

10. Verfahren nach einem der Ansprüche 1 bis 9, wobei das Gas, das eine Fluorverbindung mit Iod im Molekül enthält, mit dem reaktiven Mittel bei einer Temperatur von 500°C oder höher in Anwesenheit von Sauerstoff kontaktiert wird, wodurch die Produktion von Kohlenmonoxid unterdrückt wird.

11. Verfahren nach einem der Ansprüche 1 bis 10, wobei das Adsorptionsmittel mindestens ein Adsorptionsmittel ist, das aus der Gruppe ausgewählt ist, die aus aktiviertem Kohlenstoff, Aluminiumoxid, Kieselgel und Zeolith besteht.

12. Verfahren nach einem der Ansprüche 1 bis 11, wobei das Gas mit dem Adsorptionsmittel bei einer linearen Geschwindigkeit von 20 Nm/min. oder weniger kontaktiert wird.

13. Verfahren nach einem der Ansprüche 1 bis 12, wobei eine Schicht zum Fixieren von Iod vor der mit dem Adsorptionsmittel bepackten Schicht angebracht ist.

14. Verfahren nach Anspruch 14, wobei die Schicht zum Fixieren von Iod eine Porosität von 80-% oder mehr hat.

15. Verfahren nach einem der Ansprüche 1 bis 14, wobei die Fluorverbindung mit Iod im Molekül mindestens eine Verbindung ist, die aus der aus Fluoriodkohlenstoff, Wasserstofffluoriodkohlenstoff, Chlorfluoriodkohlenstoff und Wasserstoffchlorfluoriodkohlenstoff bestehenden Gruppe ausgewählt ist.

## Revendications

1. Procédé de décomposition d'un composé fluoré, comprenant la mise en contact d'un gaz contenant un composé fluoré ayant de l'iode à l'intérieur de la molécule avec un agent réactif contenant de l'alumine et un composé métallique alcalino-terreux, puis la mise en contact du gaz obtenu après ledit contact, avec un adsorbant.

2. Procédé selon la revendication 1, dans lequel ladite alumine est une alumine pseudo-boehmite.

3. Procédé selon la revendication 1 ou 2, dans lequel ledit composé métallique alcalino-terreux est un carbonate de magnésium, de calcium, de strontium et/ou de baryum.

4. Procédé selon l'une quelconque des revendications 1 à 3, dans lequel ledit agent réactif contient un oxyde d'au moins un métal choisi parmi le groupe consistant en le cuivre, l'étain, le nickel, le cobalt, le chrome, le molybdène, le tungstène et le vanadium.

5. Procédé selon l'une quelconque des revendications 1 à 4, dans lequel la teneur en métaux alcalins dudit agent réactif est de 0,1 % en masse ou moins.

6. Procédé selon l'une quelconque des revendications 1 à 5, dans lequel ledit agent réactif est un granule ayant une grosseur de particule de 0,5 à 10 mm.

7. Procédé selon la revendication 6, dans lequel la teneur en eau dudit agent réactif est de 1 % en masse ou moins.

8. Procédé selon l'une quelconque des revendications 1 à 7, dans lequel le composé fluoré ayant de l'iode à l'intérieur de la molécule est mis en contact avec ledit agent réactif à une température de 200°C ou plus.

9. Procédé selon l'une quelconque des revendications 1 à 8, dans lequel le gaz contenant un composé fluoré ayant de l'iode à l'intérieur de la molécule est un gaz d'échappement généré lors de l'utilisation dudit composé fluoré pour une attaque ou un nettoyage.

10. Procédé selon l'une quelconque des revendications 1 à 9, dans lequel le gaz contenant un composé fluoré ayant de l'iode à l'intérieur de la molécule est mis en contact avec ledit agent réactif à une température de 500°C ou plus en présence d'oxygène, pour limiter ainsi la production de monoxyde de carbone.

11. Procédé selon l'une quelconque des revendications 1 à 10, dans lequel ledit adsorbant est au moins un adsorbant choisi parmi le groupe consistant en le charbon actif, l'alumine, le gel de silice et la zéolite.

12. Procédé selon l'une quelconque des revendications 1 à 11, dans lequel le gaz est mis en contact avec ledit adsorbant à une vitesse linéaire de 20 Nm/min ou moins.

13. Procédé selon l'une quelconque des revendications 1 à 12, dans lequel une couche permettant de fixer l'iode est fournie devant la couche remplie dudit adsorbant.

14. Procédé selon la revendication 13, dans lequel la couche permettant de fixer l'iode a une porosité de 80 % ou plus.

15. Procédé selon l'une quelconque des revendications 1 à 14, dans lequel le composé fluoré ayant de l'iode à l'intérieur de la molécule est au moins un composé choisi parmi le groupe consistant en le fluoroiodocarbone, l'hydrofluoroiodocarbone, le chlorofluoroiodocarbone et l'hydrochlorofluoroiodocarbone.
